# EUROPEAN PATENT SPECIFICATION

(11) **EP 4 327 537 B1**
(45) Date of publication and mention of the grant of the patent: **12.08.2026**
(21) Application number: 22719188.9
(22) Date of filing: 01.04.2022
(51) Int. Cl.: H04L 67/00, G06N 5/047

(54) **RIGHT-TO-REPAIR BATTERY-REPLACEMENT METHODOLOGIES AND APPLICATIONS THEREOF**
REPARATURGERECHTE BATTERIEERSETZUNGSMETHODEN UND ANWENDUNGEN DAVON
MÉTHODOLOGIES DE REMPLACEMENT DE BATTERIE À DROIT À LA RÉPARATION ET LEURS APPLICATIONS

(43) Date of publication of application: 28.02.2024
(73) Proprietor: Google Technology Holdings LLC, Mountain View, CA 94043 (US)
(72) Inventor: LIM, James Robert, Mountain View, California 94043 (US); SHI, Shang, Mountain View, California 94043 (US); ZHANG, Haoxing, Mountain View, California 94043 (US); TSUDAMA, Kelly Jitsuo, Mountain View, California 94043 (US)
(74) Representative: Maikowski & Ninnemann Patentanwälte Partnerschaft mbB
(86) International application number: PCT/US2022/071518
(87) International publication number: WO 2023/191890

(56) References cited:
- CN-A- 107 277 136
- US-A1- 2013 015 982

## Description

### Background

Lithium-ion (Li-ion) batteries are complex and pose a safety risk if not handled properly. Right-to-repair and government regulations in regard to the ability for customers to replace embedded Li-ion batteries, from both a customer-rights perspective and a sustainability perspective, raise many challenges and opportunities. Within the industry, much effort has been placed in battery authentication to ensure the correct battery is used in an electronic device. However, there are still many ways to trick the system into accepting third-party batteries, which can introduce performance and safety issues. US 2013/0015982 A1 relates to a data collection system that collects information indicating a status of a battery mounted on a vehicle from the vehicle after shipment from a factory. The system includes a battery information collection server that is configured to periodically receive information of the battery and identification information, with which it is possible to identify the vehicle, that are transmitted wirelessly from a computer that is mounted on the vehicle and is configured to acquire and store the information of the battery mounted on the vehicle. The data collection system further comprises a battery information analysis section that is configured to display a result of associating the information of the battery received by the battery information collection server with each vehicle using the identification information. CN 107277136 A describes the matching of code images on a student card on the one hand and on a teacher card on the other hand.

### Summary

The present invention is defined by the appended claims.

The present document describes techniques associated with right-to-repair battery-replacement methodologies and applications thereof. These techniques include detecting a replacement battery in an electronic device (a new battery or the same battery reinstalled), authenticating the replacement battery, and monitoring battery characterization and health of the replacement battery. Using these techniques fulfills sustainability and right-to-repair (R2R) options, aligning with customer rights and government regulations. Further, these techniques enable replacement of an embedded battery in a user's device and detection that the replacement battery was installed and is safe for use by the device. A battery health monitor may be implemented on the device to monitor the health of the replacement battery. In some aspects, the battery health monitor may be a subscription-based service implemented via an application ("app") executed on the device or via a system-level application.

In aspects, a method for right-to-repair battery replacement is disclosed, which is performed at the electronic device. The method includes the features of claim 1.

In other aspects, an electronic device is disclosed. The electronic device includes a camera system, a memory, and one or more processors configured to execute instructions in the memory to implement a device-management application configured to communicate with the camera system to capture one or more images and perform the method described above.

This summary is provided to introduce simplified concepts of right-to-repair battery-replacement methodologies and applications thereof, which are further described below in the Detailed Description.

### Brief Description of the Drawings

The details of one or more aspects of right-to-repair battery-replacement methodologies and applications thereof are described in this document with reference to the following drawings. The same numbers are used throughout the drawings to reference like features and components:
FIG. 1 illustrates an example network environment in which aspects of right-to-repair battery-replacement methodologies and applications thereof can be implemented;
FIG. 2 illustrates an example implementation of the electronic device from FIG. 1 in more detail;
FIGs. 3A to 3D illustrate different example implementations of circuitry that enables battery-unplug detection;
FIG. 4 illustrates an example flowchart for battery replacement according to the techniques described herein;
FIG. 5 depicts an example method for pairing a replacement battery with a target device;
FIG. 6 depicts an example method for battery authentication;
FIG. 7 illustrates an example environment in which a home area network, as described with reference to FIG. 2, and aspects of right-to-repair battery-replacement methodologies and applications thereof can be implemented;
FIG. 8 illustrates an example wireless network device that can be implemented as any of the wireless network devices in a home area network in accordance with one or more aspects of right-to-repair battery-replacement methodologies and applications thereof as described herein; and
FIG. 9 illustrates an example system that includes an example device, which can be implemented as any of the wireless network devices that implement aspects of right-to-repair battery-replacement methodologies and applications thereof as described with reference to the previous FIGs. 1-8.

### DETAILED DESCRIPTION

The present document describes right-to-repair battery-replacement methodologies and applications thereof. These techniques include detection of battery replacement, authentication of the replacement battery, and battery characterization and health monitoring of the replacement battery. In an example, a user triggers a battery-replacement procedure via an application (e.g., a device-management application) and is instructed to scan a replacement-battery ID code (e.g., QR code) and a target-device ID code to pair the target device and the battery. After the battery is replaced and the target device is turned on, the target device detects that the battery was unplugged by detecting an open link (e.g., an open fuse or sense wire). After connecting the target device to an external power source, a battery-characterization profile is initiated and completed to ensure proper installation and battery function.

The techniques described herein enable owners of consumer electronics to repair and/or replace components within their devices. Also, the described techniques fulfill sustainability options under government regulations, which may require access into devices for user-performed repair or replacement, from a longevity and sustainability perspective, to ensure that devices last longer before being sent to the landfill. Further, a battery characterization feature and application may be implemented (e.g., sold, purchased) business-to-business (B2B) and business-to-consumer (B2C) in regard to subscriptions and licensing. These disclosed methodologies thereby increase the sustainability, longevity, and user satisfaction with such systems and devices.

While features and concepts of the described techniques for right-to-repair battery-replacement methodologies and applications thereof can be implemented in any number of different environments, aspects are described in the context of the following examples.

### Example Device

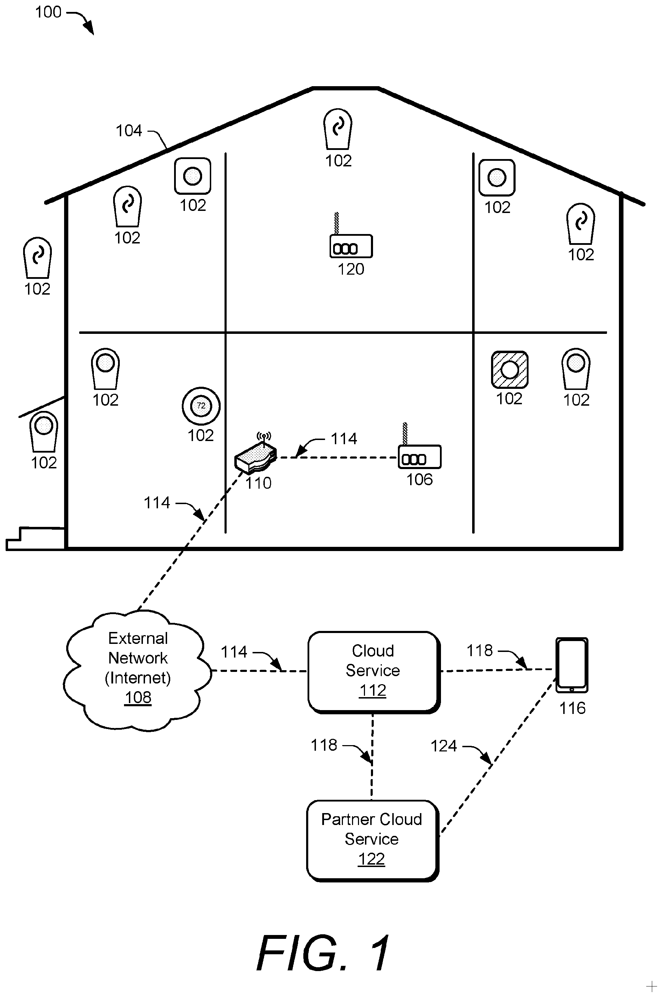

FIG. 1 illustrates an example network environment 100 in which aspects of right-to-repair battery-replacement methodologies and applications thereof can be implemented. The network environment 100 includes a home area network (HAN). The HAN includes wireless network devices 102 (e.g., electronic devices) that are disposed about a structure 104, such as a house, and are connected by one or more wireless and/or wired network technologies, as described below. The HAN includes a border router 106 that connects the HAN to an external network 108, such as the Internet, through a home router or access point 110.

To provide user access to functions implemented using the wireless network devices 102 in the HAN, a cloud service 112 connects to the HAN via a border router 106, via a secure tunnel 114 through the external network 108 and the access point 110. The cloud service 112 facilitates communication between the HAN and internet clients 116, such as apps on mobile devices, using a web-based application programming interface (API) 118. The cloud service 112 also manages a home graph that describes connections and relationships between the wireless network devices 102, elements of the structure 104, and users. The cloud service 112 hosts controllers which orchestrate and arbitrate home automation experiences, as described in greater detail below.

The HAN may include one or more wireless network devices 102 that function as a hub 120. The hub 120 may be a general-purpose home automation hub, or an application-specific hub, such as a security hub, an energy management hub, an HVAC hub, and so forth. The functionality of a hub 120 may also be integrated into any wireless network device 102, such as a smart thermostat device or the border router 106. In addition to hosting controllers on the cloud service 112, controllers can be hosted on any hub 120 in the structure 104, such as the border router 106. A controller hosted on the cloud service 112 can be moved dynamically to the hub 120 in the structure 104, such as moving an HVAC zone controller to a newly installed smart thermostat.

Hosting functionality on the hub 120 in the structure 104 can improve reliability when the user's internet connection is unreliable, can reduce latency of operations that would normally have to connect to the cloud service 112, and can satisfy system and regulatory constraints around local access between wireless network devices 102.

The wireless network devices 102 in the HAN may be from a single manufacturer that provides the cloud service 112 as well, or the HAN may include wireless network devices 102 from partners. These partners may also provide partner cloud services 122 that provide services related to their wireless network devices 102 through a partner Web API 124. The partner cloud service 122 may optionally or additionally provide services to internet clients 116 via the web-based API 118, the cloud service 112, and the secure tunnel 114.

The network environment 100 can be implemented on a variety of hosts, such as battery-powered microcontroller-based devices, line-powered devices, and servers that host cloud services. Protocols operating in the wireless network devices 102 and the cloud service 112 provide a number of services that support operations of home automation experiences in the distributed computing environment 100. These services include, but are not limited to, real-time distributed data management and subscriptions, command-and-response control, real-time event notification, historical data logging and preservation, cryptographically controlled security groups, time synchronization, network and service pairing, and software updates.

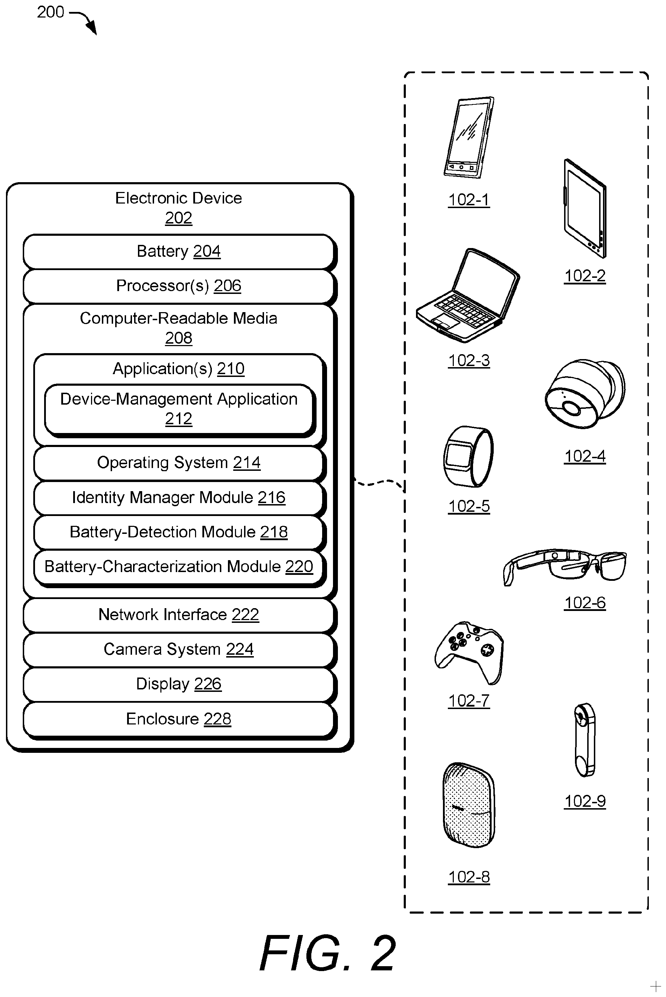

FIG. 2 illustrates an example implementation of an electronic device from FIG. 1 in more detail. The electronic device 202 (e.g., the wireless network device 102, mobile device) of FIG. 2 is illustrated with a variety of example devices, including a smartphone 202-1, a tablet 202-2, a laptop 202-3, a security camera 202-4, a computing watch 202-5, computing spectacles 202-6, a gaming system 202-7, a video-recording doorbell 202-8, and a speaker 202-9. The electronic device 202 can also include other devices, e.g., televisions, entertainment systems, desktop computers, audio systems, projectors, automobiles, drones, track pads, drawing pads, netbooks, e-readers, home security systems, camera systems, thermostats, and other home appliances. Note that the electronic device 202 can be mobile, wearable, non-wearable but mobile, or relatively immobile (e.g., desktops and appliances).

The electronic device 202 includes a battery (e.g., battery 204). The battery 204 may be any suitable rechargeable battery. As described herein, the battery 204 may be a Li-ion battery. Various different Li-ion-battery chemistries may be implemented, some examples of which include lithium cobalt oxide (LiCoO₂), lithium iron phosphate (LiFePO₄), lithium manganese oxide (LiMn₂O₄ spinel, or Li₂MnO₃-based lithium-rich layered materials, LMR-NMC), and lithium nickel manganese cobalt oxide (LiNiMnCoO₂, Li-NMC, LNMC, NMC, or NCM and the various ranges of Co stoichiometry). Also, Li-ion batteries may include various different anode materials, including graphite-based anodes, silicon (Si), graphene, and other cation intercalation/insertion/alloying anode materials.

The electronic device 202 includes one or more processors 206 (e.g., any of microprocessors, controllers, or other controllers) that can process various computer-executable instructions to control the operation of the electronic device 202 and to enable techniques for right-to-repair battery-replacement methodologies and applications thereof. The processors 206 are described in further detail below.

The electronic device 202 also includes computer-readable media 208 (CRM 208) that provides storage for various applications 210 and system data. Applications 210 and/or an operating system 214 implemented as computer-readable instructions on the computer-readable media 208 (e.g., the storage media) can be executed by the processor(s) 206 to provide some or all of the functionalities described herein. The computer-readable media 208 provides data storage mechanisms to store various device applications 210, an operating system 214, memory/storage, and other types of information and/or data related to operational aspects of the electronic device 202. For example, the operating system 214 can be maintained as a computer application within the computer-readable media 208 and executed by the processor(s) 206 to provide some or all of the functionalities described herein. The device applications 210 may include a device manager, such as any form of a control application, software application, or signal-processing and control modules. The device applications 210 may also include system components, engines, or managers to implement techniques for right-to-repair battery-replacement methodologies and applications thereof, such as an identity-manager module 216, a battery-detection module 218, a battery-characterization module 220, and so on. The electronic device 202 may also include, or have access to, one or more machine learning systems.

Various implementations of the identity-manager module 216, battery-detection module 218, and the battery-characterization module 220 can include, or communicate with, a System-on-Chip (SoC), one or more Integrated Circuits (ICs), a processor with embedded processor instructions or configured to access processor instructions stored in memory, hardware with embedded firmware, a printed circuit board with various hardware components, or any combination thereof.

The identity-manager module 216 is configured to obtain a battery identifier (e.g., battery ID) from an image (e.g., first image), captured by an image-capturing device (e.g., a camera), of an ID code, such as a machine-readable optical label (e.g., QR code, bar code, unique graphic), associated with the replacement battery. Also, the identity-manager module 216 is configured to obtain a device ID from an image (e.g., second image) captured by the image-capturing device from an ID code associated with the electronic device 202. In another example, the battery ID and/or the device ID can be obtained from an image of a non-fungible token (NFT) or other unique symbol or code associated with the battery and/or the device, respectively.

The battery-detection module 218 is configured to detect a battery identification (e.g., battery ID) of a battery that is installed in or coupled to the electronic device 202. Using the detected battery ID, the battery-detection module 218 can authenticate that the battery is an authorized battery and/or that the detected battery ID matches the battery ID obtained from the previously scanned ID code.

The battery-detection module 218 may use any suitable method for detecting the battery ID and authenticating the battery. In one example, the battery-detection module 218 may measure a voltage drop across a resistor on a connector inside a battery pack, which can be used to determine a particular version of the battery. In another example, the battery-detection module 218 can perform a handshake with an integrated circuit inside the battery pack. In such a case, the battery pack may include an erasable programmable read-only memory (EPROM) chip or an electrically erasable programmable read-only memory (EEPROM) chip that stores the battery ID and/or other information corresponding to the battery pack, including capacity information of the battery pack. Such functionalities can also be implemented via a discrete fuel gauge and integrated power management integrated circuit (PMIC) chip. Using a challenge/response scheme, the battery-detection module 218 can send a command to the battery pack and read back data in a response from the battery pack. The data may include a family code, a unique ID (e.g., battery ID), or other information usable to identify the battery pack. In another example, a pin can be used to communicate with the integrated circuit in the battery pack, which enables the battery-detection module 218 to read inside the integrated circuit, which was programmed by the manufacturer, to obtain the battery ID.

In another example, an encrypted authentication architecture (e.g., challenger and responder) may be used, which may provide an additional layer of security. For instance, both the challenger (e.g., the electronic device 202) and responder (e.g., the integrated circuit in the battery pack) may have a secret key usable with an authentication transform algorithm (e.g., SHA-1) to calculate an answer for the challenge. Then, the challenger can authenticate the responder if its own calculated answer matches the responder's answer.

The battery-characterization module 220 is configured to characterize the replacement battery and generate a battery-characterization profile that represents a state of health of the replacement battery. For example, the battery-characterization module 220 is configured to run a charge/discharge profile on the battery to determine battery health. Any suitable charge/discharge profile may be executed, including a step charge profile and a step discharge profile. The battery-characterization module 220 monitors the behavior (e.g., charge rate, discharge rate) of the battery during execution of the charge/discharge profile to learn battery impedance, capacity, and state of health.

The electronic device 202 may also include a network interface 222. The electronic device 202 can use the network interface 222 for communicating data over wired, wireless, optical, or audio (e.g., acoustic) networks. By way of example and not limitation, the network interface 222 may communicate data over a local-area-network (LAN), a wireless local-area-network (WLAN), a home area network (HAN), a personal-area-network (PAN), a wide-area-network (WAN), an intranet, the Internet, a peer-to-peer network, point-to-point network, or a mesh network. The network interface 222 can be implemented as one or more of a serial and/or parallel interface, a wireless interface, any type of network interface, a modem, or any other type of communication interface. Using the network interface 222, the electronic device 202 may communicate via a cloud computing service (e.g., the cloud service 112) to access a platform having resources.

The electronic device 202 also includes a camera system 224. The camera system 224 is configured to capture images, video, and/or audio. Any suitable camera system 224 may be implemented in or communicatively coupled to the electronic device 202. The camera system 224 may be a digital camera that converts light captured by a lens to digital data representing a scene within the field of view of the lens. Also, the camera system 224 can be used to scan the ID code (e.g., QR code, bar code) associated with the battery pack and/or the device. The camera system 224 can also include audio functionality configured to provide and receive audio communication. The audio functionality may be provided by integrated audio sensors for receiving audio input (e.g., via a microphone) and/or providing audio output (e.g., via a speaker). In an example, if the camera is disabled or inactive, the audio functionalities of the electronic device 202 can listen for and detect a voice input (e.g., the user reading aloud) of the serial number or bar code numbers. Such voice input can also be voice authenticated via an application on the electronic device 202 to verify that the voice belongs to the owner of the electronic device 202.

The electronic device 202 can also include a display 226 (e.g., display device 226). The display 226 can include any suitable touch-sensitive display device, e.g., a touchscreen, a liquid crystal display (LCD), thin film transistor (TFT) LCD, an in-place switching (IPS) LCD, a capacitive touchscreen display, an organic light-emitting diode (OLED) display, an active-matrix organic light-emitting diode (AMOLED) display, super AMOLED display, and so forth. The display 226 may be referred to as a display or a screen, such that digital content may be displayed on-screen.

The electronic device 202 also includes an enclosure 228 (e.g., housing). The enclosure 228 houses the various components of the electronic device 202, including, for example, the battery 204 and the camera system 224. In aspects, the enclosure 228 includes at least two portions that are coupled together. The at least two portions of the enclosure 228 can be tightly fitted together with seals to prevent dust and water ingress into the circuitry and other components housed within the enclosure 228. The portions of the enclosure 228 may also include a physical link (e.g., fuse or sense line), which completes a circuit when the enclosure 228 is closed at factory assembly and which is broken upon opening the enclosure 228. The link may be used by the electronic device 202 to determine if the enclosure has been tampered with (e.g., opened) post-assembly. Such an indication of tampering indicates a likelihood that one or more internal components (e.g., the battery 204) may have been removed and/or replaced or that one or more objects may have been added within the enclosure. In an example, the physical link may be measured by an analog-to-digital converter (ADC) or equivalent. After factory assembly and prior to the enclosure being opened, the ADC can measure "1" on the physical link, indicating a short or complete circuit. After the enclosure is opened, the physical link is broken and the ADC measures a "0" on the physical link, indicating an open circuit. After breaking, the physical link remains open even after the enclosure is closed, which enables the electronic device 202 to detect that the enclosure 228 has been opened at least once after factory assembly (and likely by the consumer).

These and other capabilities and configurations, as well as ways in which entities of FIGs. 1 and 2 act and interact, are set forth in greater detail below. These entities may be further divided, combined, and so on. The network environment 100 of FIG. 1 and the detailed illustrations of FIG. 2 through FIG. 9 illustrate some of many possible environments, devices, and methods capable of employing the described techniques, whether individually or in combination with one another.

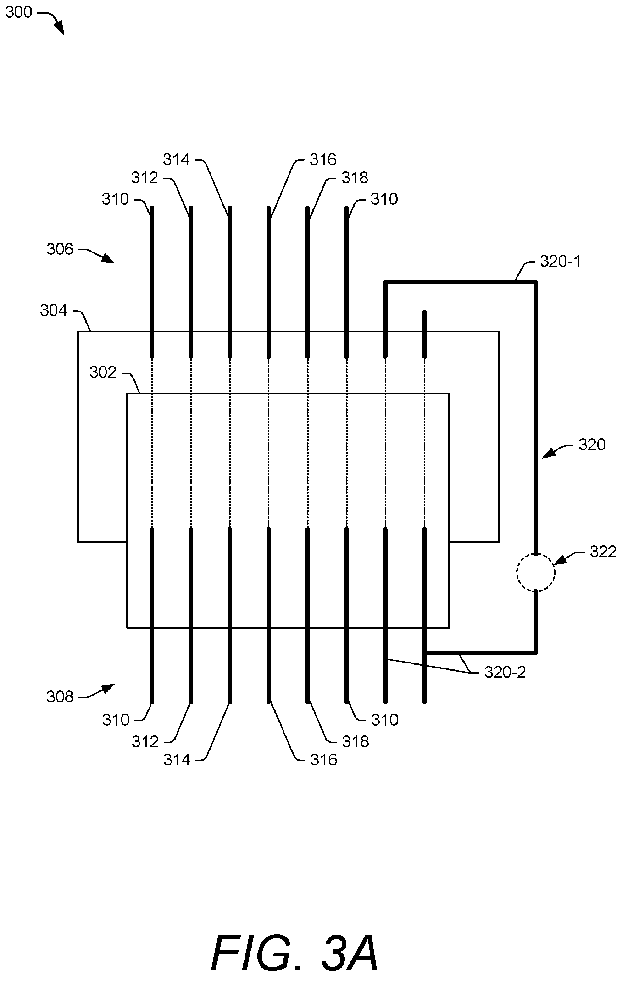

FIGs. 3A to 3D illustrate different example implementations of circuitry that enables battery-unplug detection. FIG. 3A illustrates an example implementation 300 of a battery-side connector 302 coupled to a device-side connector 304. The device-side connector 304 includes electrical wiring 306 and the battery-side connector 302 includes corresponding wiring 308. The wiring 306 and 308 include various lines, some examples of which include one or more power lines 310 (e.g., positive and negative power), data lines 312, clock lines 314, thermistor lines 316, and battery ID lines 318. The wiring 306 and 308 may include an additional, external sense line 320 (e.g., sense lines 320-1 and 320-2, respectively), which may be used to detect when the battery 204 is disconnected from the electronic device 202.

The sense line 320 may be open (e.g., at opening 322) until factory assembly, where the battery-side connector 302 is coupled to the device-side connector 304 and the sense line 320-1 is physically and electrically coupled to the sense line 320-2. In an example, the opening 322 may be a fuse or open circuit. Then, the sense lines 320-1 and 320-2 may be paired or coupled together to close the opening 322 using, for example, a soldering joint, additional wire, or any other suitable electrically conductive coupling mechanism that electrically connects the sense lines 320-1 and 320-2 together. Such a coupling mechanism may provide a relatively weak point in the sense line 320 that fails (e.g., breaks) when the battery-side connector 302 is decoupled from the device-side connector 304 (e.g., when the battery 204 is removed from the electronic device 202).

The electronic device 202 may have an ADC or equivalent that measures a closed loop (e.g., 1 bit) in the sense line 320 after factory assembly. Subsequent to the factory assembly, when the battery 204 is removed by a user, the sense line 320 is broken. Then, when a replacement battery is installed and the device is turned on, the ADC measures an open circuit (e.g., 0 bit) in the sense line 320, which indicates that the original battery has been tampered with (e.g., removed). There is also a likelihood that the currently installed battery is not the original battery.

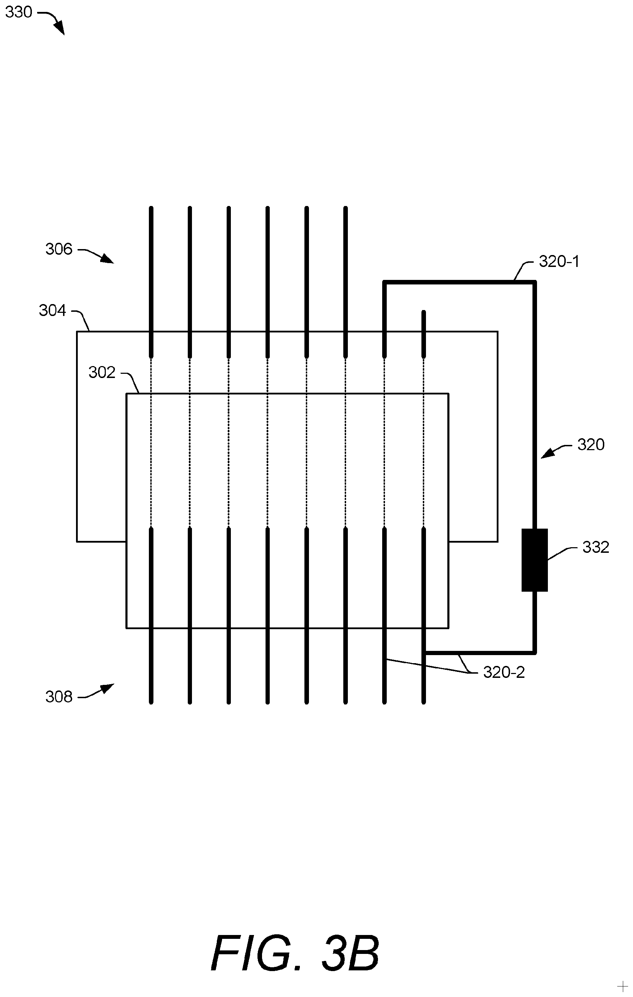

FIG. 3B illustrates another example implementation 330 of the battery-side connector 302 coupled to the device-side connector 304. Similar to the example implementation 300 in FIG. 3A, the implementation 330 illustrates the device-side connector 304, which has electrical wiring 306, coupled to the battery-side connector 302, which has corresponding wiring 308. In FIG. 3B, the weak point in the sense line 320 is filled with a conductive material 332 to create a short in the sense line 320. The conductive material 332 may be a conductive epoxy or other brittle conductive filler that breaks the conductive path in the sense line 320 when the battery-side connector 302 is decoupled (e.g., unplugged) from the device-side connector 304.

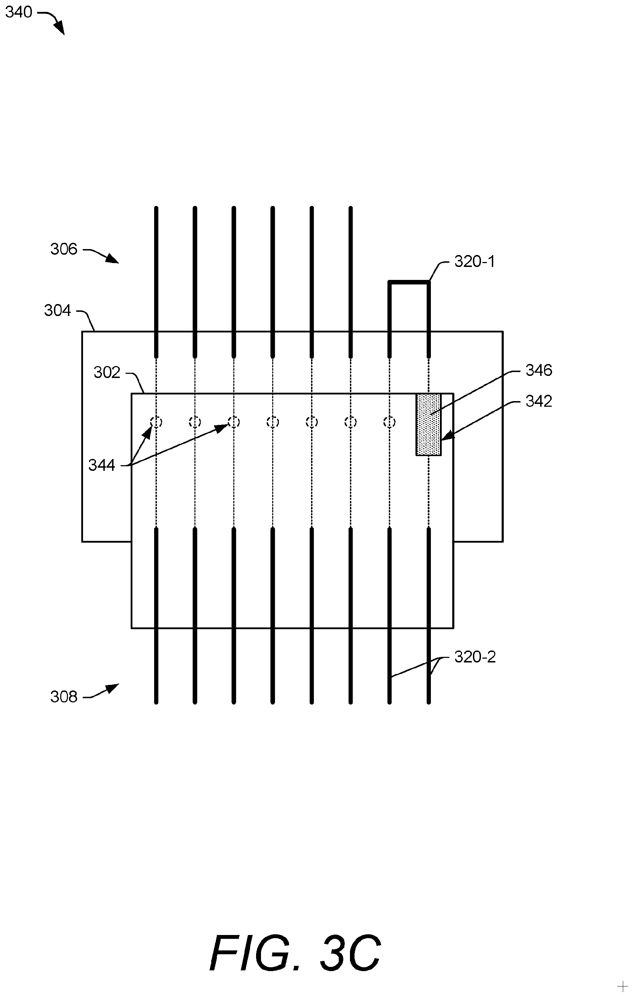

FIG. 3C illustrates yet another example implementation 340 of a battery-side connector 302 coupled to a device-side housing connector 304. In aspects, the battery-side connector 302 may include an opening 342 (e.g., slot, notch). The connectors 302 and 304 may use pins (e.g., pins 344) to engage the electrical wiring 306 with the corresponding wiring 308. However, in the illustrated example, the opening 342 may be formed in place of one of the pins, such as at a location where the one pin would otherwise connect the sense lines 320-1 and 320-2. As a result, when the battery-side connector 302 is coupled to the device-side connector 304, the sense line 320 remains open due to the opening 342 in the battery-side connector 302.

During factory assembly, the opening 342 can be filled with a conductive material 346 (e.g., conductive epoxy or other brittle conductive material) to close the sense line 320 by providing a conductive path between the sense lines 320-1 and 320-2. In aspects, the conductive material 346 may be opaque to the user and flush with an exterior surface of the battery-side connector 302. Further, the conductive material 346 may color match a color of the battery-side connector 302 to be less obvious to the user and reduce the likelihood of counterfeits and/or the user tricking the system. When the user removes the battery 204 from the electronic device 202 the conductive material 346 breaks the connection in the sense line 320 and when a replacement battery (e.g., third party battery) is installed, the sense line 320 remains open. The open sense line 320 results in a 0-bit reading by the ADC, which indicates that the replacement battery is not the original battery. Even if the same connector (or same type of connector) is used as a replacement, the opening 342 won't be filled with the conductive material 346 and the system reads the line as broken and the ADC records the line as "0," indicating that the battery 204 has been tampered with.

### Example workflow

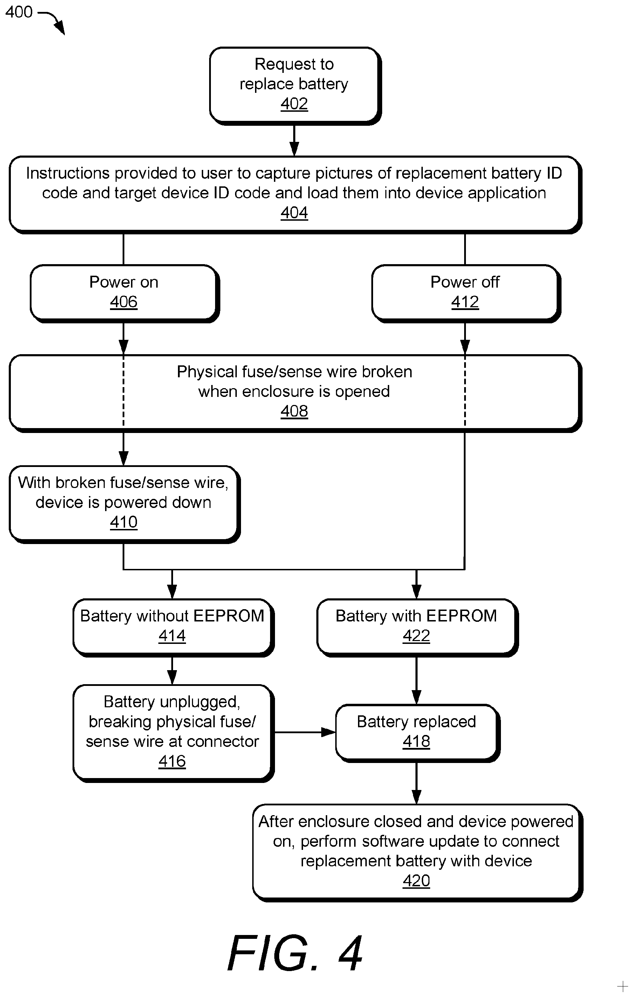

FIG. 4 illustrates an example flowchart 400 for battery replacement according to the techniques described herein. At block 402, a device receives a request to replace the battery. In aspects, the request may be triggered by a user. For example, the user may provide a user input via a device application (e.g., the application 210) running on the electronic device 202 to request to replace the battery 204 in a target device (e.g., the electronic device 202 or another device communicatively coupled to the electronic device 202, such as a wireless network device 102). In other aspects, the request may be generated by the electronic device 202, based on detection of poor battery health or other problems with the battery 204 embedded in the electronic device 202.

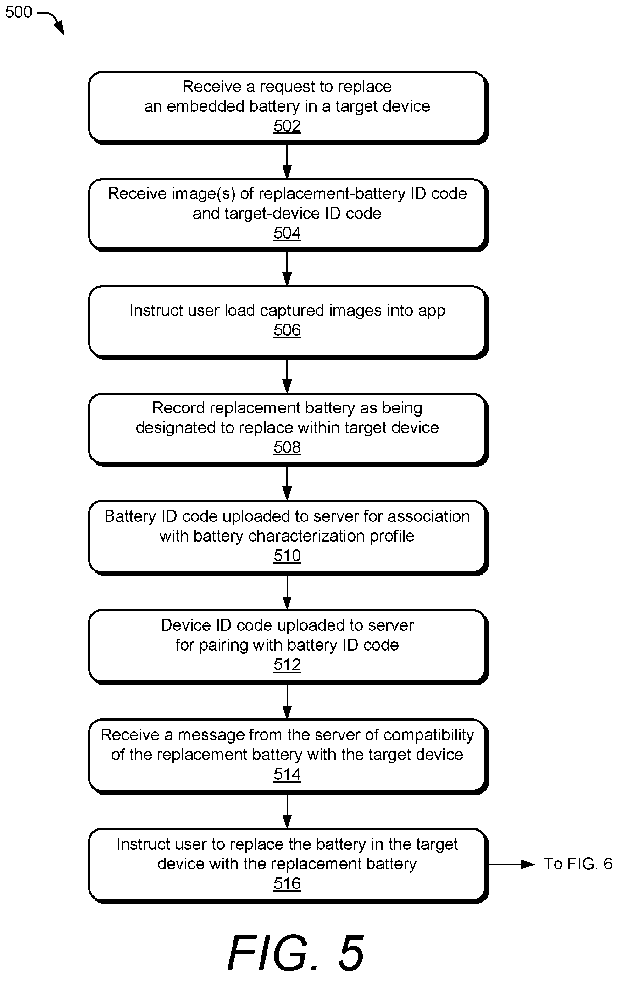

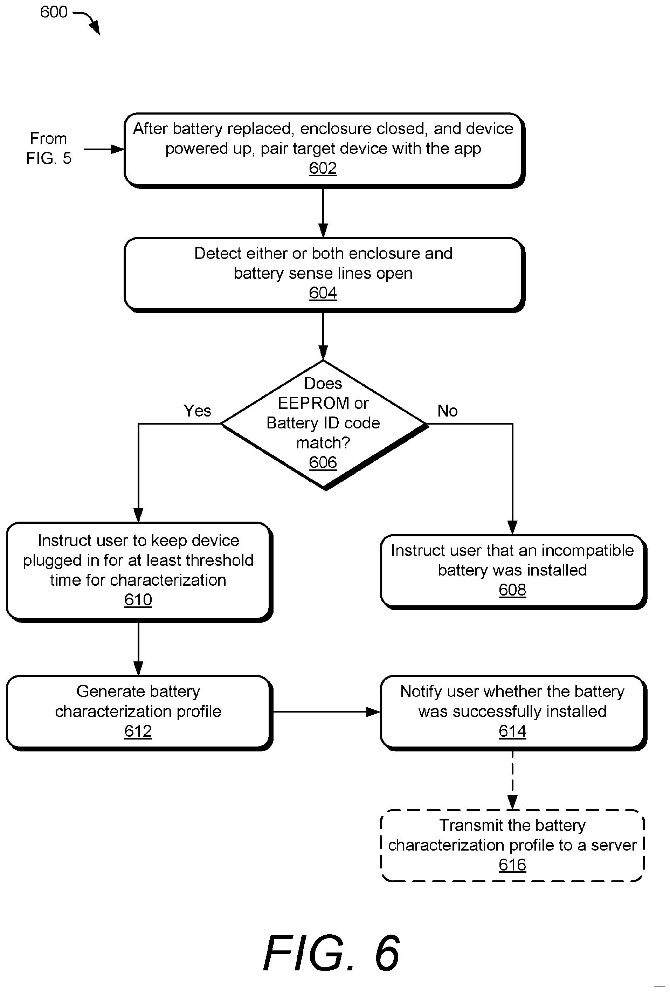

In response to the request to replace the battery in the target device, at block 404 instructions are provided to the user to capture images of the replacement-battery ID code and the target-device ID code and load the images into the device application. As is described in further detail in FIGs. 5 and 6, the captured images can be uploaded to a server to pair the replacement battery with the target device. Such device-battery pairing at the server may include verifying a compatibility between the battery and the device.

If the target device's power is on (e.g., block 406), then at block 408 an additional sense line or fuse is broken when the user opens the device enclosure and at block 410, the device is powered down responsive to the broken fuse or sense wire. In an example, the additional sense line or fuse connects at least two portions of the enclosure 228 of the target device and is physically broken (e.g., sheared, disconnected) when the enclosure 228 is opened.

If, prior to the enclosure being opened at block 408, the target device's power is first turned off (e.g., block 412), then after the enclosure is opened at block 408, the flow skips block 410 because the target device is already powered down.

The flowchart then diverges based on whether the battery includes or does not include an EEPROM. If the battery does not have an EEPROM (e.g., block 414), then at block 416, a physical fuse or sense line is broken at the battery connector when the battery is decoupled (e.g., unplugged). For example, the sense line 320 is physically broken at its weak point (e.g., soldering joint, the conductive material 332, the conductive material 346) when the battery-side connector 302 is separated from the device-side connector 304. Then at block 418, the battery is replaced by the user and at block 420, after the enclosure is closed and the target device is powered on, the target device performs a software update to connect the replacement battery with the target device. In one example, when the electronic device 202 is powered on, it performs a software update to authenticate the battery 204 and pair the battery 204 with the electronic device 202. The target device also reads the fuse or sense line, which is now broken (e.g., open), and determines that the original battery has been tampered with (e.g., removed).

If the battery does have an EEPROM (e.g., block 422), then the flowchart 400 proceeds directly to block 418 where the battery is replaced and at block 420, after the enclosure is closed and the target device powered on, a software update is performed to connect the replacement battery with the target device. The EEPROM includes battery information that the target device can use to determine that the replacement battery is not the original battery.

### Example Methods

FIGs. 5 and 6 depict example methods 500 and 600, respectively, for right-to-repair battery replacement as described herein. FIG. 5 depicts an example method for pairing a replacement battery with a target device. FIG. 6 depicts an example method for battery authentication.

The methods 500 and 600 can be performed by the electronic device 202, which uses the identity-manager module 216, the battery-detection module 218, and/or the battery-characterization module 220 to implement the described techniques. The methods 500 and 600 collectively provide enhanced sustainability for the electronic device 202, reliability for the battery 204, and user experience for the consumer. The method 600 is supplemental to, and is optionally performed in conjunction with, the method 500.

The methods 500 and 600 are shown as a set of blocks that specify operations performed but are not necessarily limited to the order or combinations shown for performing the operations by the respective blocks. Further, any of one or more of the operations may be repeated, combined, reorganized, or linked to provide a wide array of additional and/or alternate methods. In portions of the following discussion, reference may be made to the example network environment 100 of FIG. 1 or to entities or processes as detailed in FIGs. 2-4, reference to which is made for example only. The techniques are not limited to performance by one entity or multiple entities operating on one device.

At 502, a request to replace an embedded battery in a target device is received. For example, a user input may be received by the electronic device 202 and may include a request to replace the battery 204 in the electronic device 202. In aspects, the user input may be received via an application (e.g., application 210) running on the electronic device 202. In another example, the user input received by the electronic device 202 may include a request to replace a battery in a remote device communicatively coupled to the electronic device 202 (e.g., a wireless network device 102 in communication with the electronic device 202 via the HAN). In one example, the user interacts with an application on a mobile phone to request replacement of a battery embedded in a smart thermostat device. In another example, the target device may generate the request to replace its battery and transmit the request to the electronic device 202.

At 504, one or more images of a replacement-battery ID code (e.g., first image) and a target-device ID code (e.g., second image) is received. For example, the electronic device 202 presents instructions to the user in the form of text, audio, and/or a video in response to the request to instruct the user to capture the images using a camera. In one example, the ID codes for the replacement battery and the target device are QR codes printed on labels adhered to the replacement battery and the target device, respectively. The instructions may also direct the user to capture an image of the replacement battery (e.g., third image). In one example, receiving the request at 502 and receiving the image(s) at 504 are a single operation.

At 506, the user is instructed to load the captured images into the application. For example, electronic device 202 provides instructions to the user to enable the application to access the captured images. In some aspects, the application can access the camera system 224 of the electronic device 202 to automatically load the image(s) into the application when the image(s) is captured or in response to another user input that confirms that the captured image(s) is acceptable. In another example, the instructions include instructions for the user to enable the electronic device 202 to upload the captured images to the cloud service 112 to enable the cloud service 112 to associate the replacement-battery ID code with the target-device ID code. Further, the cloud service 112 may use the image of the replacement battery for verification of the replacement-battery ID code (e.g., to reduce counterfeit batteries being used). For example, the cloud service 112 can verify whether the replacement-battery ID code corresponds to a battery that is at least geometrically similar (e.g., shape, size) to the replacement battery in the image.

At 508, the battery is recorded as being designated as a replacement battery for the target device. For example, the application 210 associates the replacement-battery ID code of the replacement battery with the electronic device 202 to indicate that the replacement battery is to be installed to replace the original battery of the electronic device 202. If the target device is a remote device, the application 210 associates the replacement-battery ID code of the replacement battery with the target-device ID code to indicate that the replacement battery is designated to replace the battery in the remote target device.

At 510, the replacement-battery ID code is transmitted (e.g., uploaded) to the server for association with a battery characterization profile. In one example, the electronic device 202 transmits the captured image of the replacement-battery ID code (e.g., QR code) to the cloud service 112 to enable the cloud service 112 to obtain an identifier (e.g., battery ID) of the replacement battery from the replacement-battery ID code. In another example, the electronic device 202 obtains the replacement-battery ID code from the captured image and transmits the replacement-battery ID code to the cloud service 112. In yet another example, the electronic device 202 obtains the battery ID from the replacement-battery ID code in the captured image and transmits the battery ID to the cloud service 112. The cloud service 112 uses the battery ID to associate the replacement battery with a known or stored characterization profile that corresponds to the replacement battery or the type of battery. The stored characterization profile provides an indication of how the replacement battery should perform.

At 512, the target-device ID code is uploaded to the server for pairing with the replacement-battery ID code. In one example, the electronic device 202 transmits the captured image of the target-device ID code (e.g., QR code) to the cloud service 112. In another example, the electronic device 202 obtains the target-device ID code from the captured image and transmits the target-device ID code to the cloud service 112 to enable the cloud service 112 to obtain a target-device identifier (e.g., target-device ID) of the target device from the target-device ID code. The cloud service 112 pairs the target-device ID with the replacement-battery ID. This pairing enables the cloud service 112 to determine the compatibility of the replacement battery with the target device.

At 514, a message is received from the server of the compatibility of the replacement battery with the target device. For example, the electronic device 202 receives a communication from the cloud service 112 that, according to the uploaded battery ID and device ID codes, the replacement battery is compatible with the target device and may be safely installed in the target device. In another example, the message from the cloud service 112 may indicate that the replacement battery designated to be installed in the target device is not compatible and should not be installed in the target device.

At 516, the user is instructed to replace the battery in the target device with the replacement battery. For example, in response to receiving the message of compatibility indicating that the replacement battery is compatible with the target device, the electronic device 202 presents instructions to the user to proceed with installing the replacement battery in the target device.

The method 500 then proceeds to FIG. 6, which depicts an example method for battery authentication. At 602, after the battery is replaced and the enclosure is closed, the target device is powered up and paired with the app. For example, if the app is executed on the electronic device 202 and the target device is a remote device, the target device is paired with the app on the electronic device 202 via a network (e.g., the HAN, the external network 108) or a direct wireless connection established between the electronic device 202 and the target device. In another example, if the electronic device 202 is the target device, then the electronic device 202 executes the app.

At 604, the device detects if either or both of the enclosure and battery sense lines are open. If the sense line 320 of the battery pack and/or the sense line of the enclosure is open, the target device detects an open circuit and determines that the battery has been tampered with. The target device's ADC can, for example, read a "0" on the sense line, indicating that the sense line is open.

At 606, the device determines if the EEPROM or the battery ID code match. For example, if the replacement battery has an EEPROM onboard fuel gauge, then the replacement battery may have a communication chip configured to at least perform a handshake with the target device (e.g., with the battery-detection module 218). Based on the handshake with the communication chip in the EEPROM on the replacement battery, the battery-detection module 218 can determine if the replacement battery is the same battery that was designated by the application to be installed in the target device.

A similar detection can be made based on a comparison of the battery ID code, obtained from the captured image (e.g., QR code), with an ID code detected from the replacement battery. If the battery ID code matches the detected ID code, then the device authenticates the replacement battery as the same battery that was designated by the application to be installed in the target device.

If the EEPROM or the battery ID code does not match ("NO" at 606), then at 608, the device instructs the user that an incompatible battery was installed. The device may further inform the user that the device cannot use the incompatible battery and may instruct the user to remove the incompatible battery. The device may then shut down.

If the EEPROM or the battery ID code does match ("YES" at 606), then at 610, the device instructs the user to keep the target device plugged in for at least a threshold amount of time (e.g., 8 hours, 12 hours, 24 hours) for characterization of the replacement battery. For example, the app running on the electronic device 202 may notify the user to leave the target device connected to line power overnight to enable the target device to execute a battery characterization process. For additional safety, the device may also instruct the user to place the target device in a safe area (e.g., away from any flammable materials or substances) in case the battery overheats during the characterization process.

At 612, the target device generates a battery characterization profile. In aspects, the target device generates the battery characterization profile by running a charge/discharge profile. The charge/discharge profile may include step charging and/or step discharging the battery at various charge and discharge rates, respectively, to monitor the battery's response and behavior, such as frequency response time, temperature, and so on. The battery characterization profile provides information relating to the general health of the battery (e.g., actual performance metrics relative to its design specifications). For example, the battery characterization profile may indicate that the battery is or is not charging correctly based on a particular charge rate applied to the battery over a predetermined amount of time. Further, the target device can disable the connection to the line power (e.g., external power source) and perform one or more operations that consume certain amounts of power (e.g., play a video with a particular level of audio and/or display the video with a particular brightness, resolution, and color) to discharge the battery and monitor the duration of time for the battery state-of-charge to reach a threshold level state-of-charge. In some implementations, the device may run the charge/discharge profile multiple times (e.g., 2, 3, 4, 5) over a duration of time (e.g., overnight, 4 hours, 6 hours). Determining the battery health enhances safety for the target device and for the user.

At 614, the user is notified whether the replacement battery was successfully installed. For example, the electronic device 202 may provide a notification, via the application 210, of successful installation of the replacement battery and that the replacement battery is sufficiently healthy for use by the target device. In this context, a healthy battery is a battery that is safe (e.g., meets one or more safety standards) to use for operation of the target device and not likely to cause damage or harm (e.g., by overheating). A healthy battery may not necessarily meet the original design specifications of the battery but may be safely used by the target device for battery power. If the battery is determined to not be healthy (e.g., fails one or more safety standards), the electronic device 202 may notify the user, via the application 210, that installation of the battery was unsuccessful and/or there was a problem with the installation of the battery.

Optionally, at 616, the battery characterization profile is transmitted to the server. For example, the electronic device 202 can transmit the battery characterization profile, which was generated for the replacement battery, to the cloud service 112 to enable the cloud service 112 to track the target device with respect to the replacement battery installed in the target device. The cloud service 112 can monitor the battery health of the replacement battery installed in the target device over a duration of time. The cloud service 112 may utilize any suitable algorithm or model associated with charge/discharge curves, including machine learning models, to determine and track the battery health. Such tracking of the battery health may enable the cloud service 112 to verify that the target device is safe for travel and meets regulations (e.g., regulations for traveling by airplane, local government regulations). The cloud service 112 can provide device-battery pairing information to a requesting entity (e.g., government, international organization), where the pairing information includes a battery health status of the replacement battery in the target device.

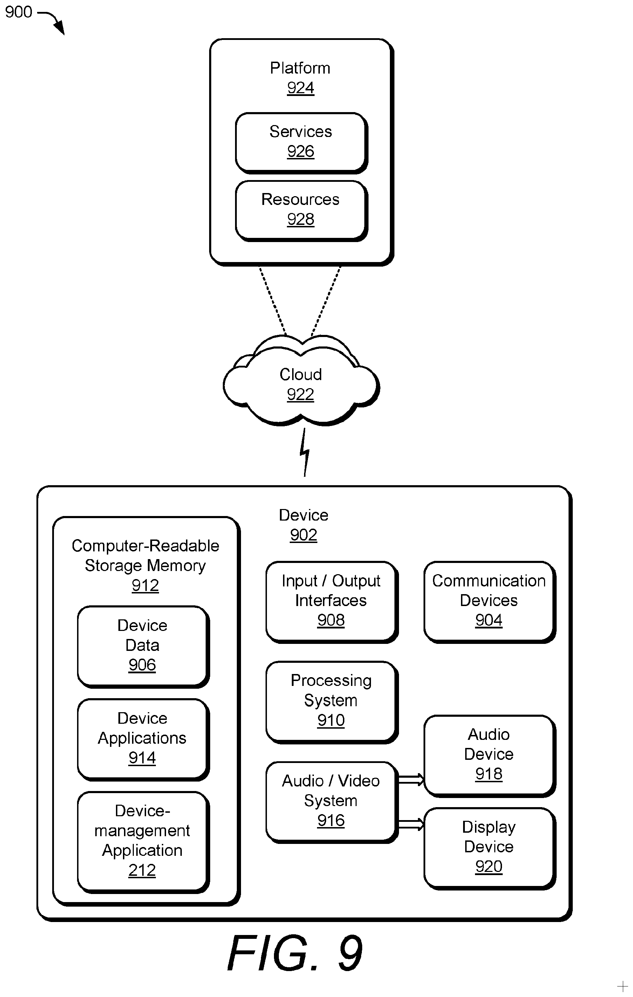

In aspects, the battery health monitoring service provided by the cloud service 112 may be subscription-based. In other aspects, the cloud service 112 may provide the battery-health monitoring service as part of a service agreement with a service provider for the electronic device 202. In this way, over time, the battery-health monitoring service can monitor the battery health and notify the user of issues (e.g., battery temperature exceeding a threshold limit, not charging or discharging properly) with the replacement battery and/or that the replacement battery needs to be replaced. The battery-health monitoring service may track the battery health of various batteries paired with various devices to provide data regarding such replacement batteries, particularly third-party batteries. Such data may be helpful in making recommendations to a user of comparable options (better or worse) for replacement batteries to install in a particular device. These recommendations can be provided to the user via an application 210, including a device-management application described in FIG 9.

### Example Environments and Devices

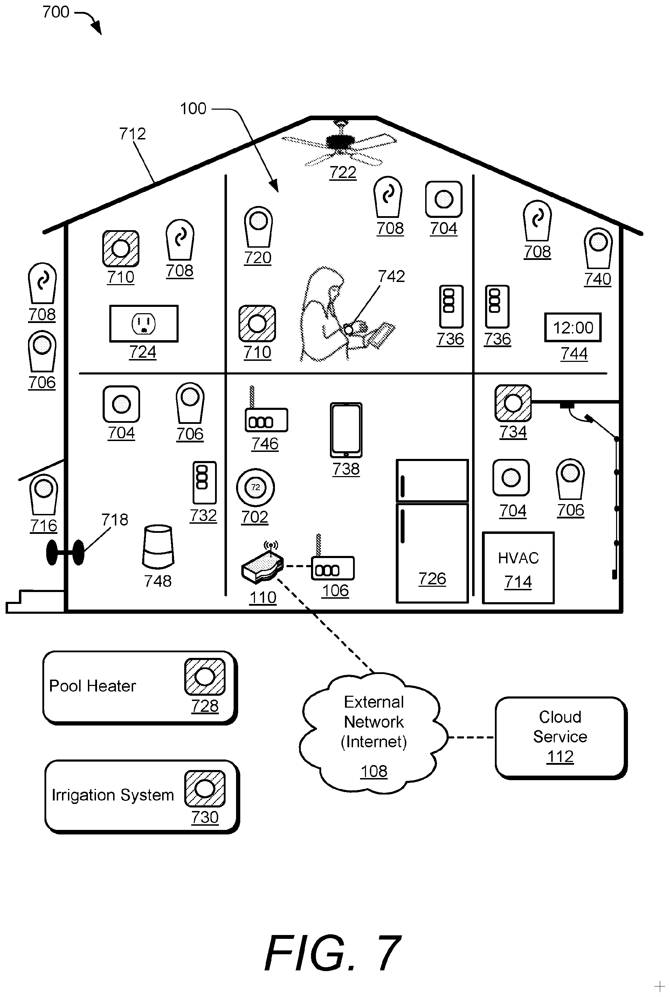

FIG. 7 illustrates an example environment 700 in which a home area network, as described with reference to FIG. 1, and aspects of right-to-repair battery-replacement methodologies and applications thereof can be implemented. Generally, the environment 700 includes the home area network (HAN) implemented as part of a home or other type of structure with any number of wireless network devices (e.g., wireless network devices 102) that are configured for communication in a wireless network. For example, the wireless network devices can include a thermostat 702, hazard detectors 704 (e.g., for smoke and/or carbon monoxide), cameras 706 (e.g., indoor and outdoor), lighting units 708 (e.g., indoor and outdoor), and any other types of wireless network devices 710 that are implemented inside and/or outside of a structure 712 (e.g., in a home environment). In this example, the wireless network devices can also include any of the previously described devices, such as a border router 106, as well as the electronic device 202.

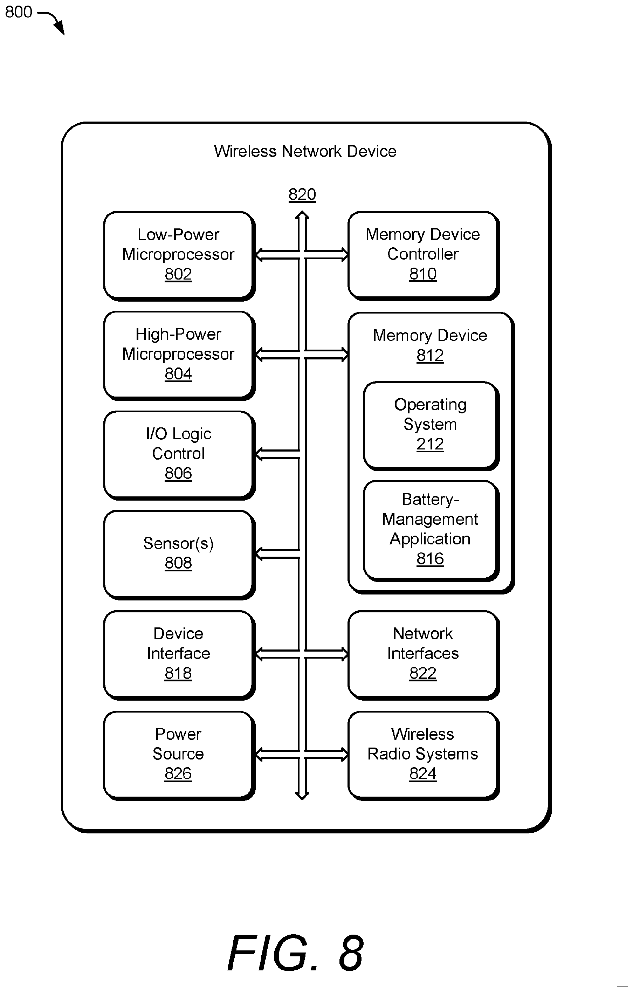

In the environment 700, any number of the wireless network devices can be implemented for wireless interconnection to wirelessly communicate and interact with each other. The wireless network devices are modular, intelligent, multi-sensing, network-connected devices that can integrate seamlessly with each other and/or with a central server or a cloud-computing system to provide any of a variety of useful automation objectives and implementations. An example of a wireless network device that can be implemented as any of the devices described herein is shown and described with reference to FIG. 8.

In implementations, the thermostat 702 may include a Nest^{®} Learning Thermostat that detects ambient climate characteristics (e.g., temperature and/or humidity) and controls an HVAC system 714 in the home environment. The learning thermostat 702 and other network-connected devices "learn" by capturing occupant settings to the devices. For example, the thermostat learns preferred temperature set-points for mornings and evenings, and when the occupants of the structure are asleep or awake, as well as when the occupants are typically away or at home.

A hazard detector 704 can be implemented to detect the presence of a hazardous substance or a substance indicative of a hazardous substance (e.g., smoke, fire, or carbon monoxide). In examples of wireless interconnection, a hazard detector 704 may detect the presence of smoke, indicating a fire in the structure, in which case the hazard detector that first detects the smoke can broadcast a low-power wake-up signal to all of the connected wireless network devices. The other hazard detectors 704 can then receive the broadcast wake-up signal and initiate a high-power state for hazard detection and to receive wireless communications of alert messages. Further, the lighting units 708 can receive the broadcast wake-up signal and activate in the region of the detected hazard to illuminate and identify the problem area. In another example, the lighting units 708 may activate in one illumination color to indicate a problem area or region in the structure, such as for a detected fire or break-in, and activate in a different illumination color to indicate safe regions and/or escape routes out of the structure.

In various configurations, the wireless network devices 710 can include an entryway interface device 716 that functions in coordination with a network-connected door lock system 718, and that detects and responds to a person's approach to or departure from a location, such as an outer door of the structure 712. The entryway interface device 716 can interact with the other wireless network devices based on whether someone has approached or entered the smart-home environment. An entryway interface device 716 can control doorbell functionality, announce the approach or departure of a person via audio or visual means, and control settings on a security system, such as to activate or deactivate the security system when occupants come and go. The wireless network devices 710 can also include other sensors and detectors, such as to detect ambient lighting conditions, detect room-occupancy states (e.g., with an occupancy sensor 720), and control a power and/or dim state of one or more lights. In some instances, the sensors and/or detectors may also control a power state or speed of a fan, such as a ceiling fan 722. Further, the sensors and/or detectors may detect occupancy in a room or enclosure and control the supply of power to electrical outlets or devices 724, such as if a room or the structure is unoccupied.

The wireless network devices 710 may also include connected appliances and/or controlled systems 726, such as refrigerators, stoves and ovens, washers, dryers, air conditioners, pool heaters 728, irrigation systems 730, security systems 732, and so forth, as well as other electronic and computing devices, such as televisions, entertainment systems, computers, intercom systems, garagedoor openers 734, ceiling fans 722, control panels 736, and the like. When plugged in, an appliance, device, or system can announce itself to the home area network as described above and can be automatically integrated with the controls and devices of the home area network, such as in the home. It should be noted that the wireless network devices 710 may include devices physically located outside of the structure, but within wireless communication range, such as a device controlling a swimming pool heater 728 or an irrigation system 730.

As described above, the HAN includes a border router 106 that interfaces for communication with an external network, outside the HAN. The border router 106 connects to an access point 110, which connects to the external network 108, such as the Internet. A cloud service 112, which is connected via the external network 108, provides services related to and/or using the devices within the HAN. By way of example, the cloud service 112 can include applications for connecting end-user devices 738, such as smartphones, tablets, and the like, to devices in the home area network, processing and presenting data acquired in the HAN to end-users, linking devices in one or more HANs 200 to user accounts of the cloud service 112, provisioning and updating devices in the HAN, and so forth. For example, a user can control the thermostat 702 and other wireless network devices in the home environment using a network-connected computer or portable device, such as a mobile phone or tablet device. Further, the wireless network devices can communicate information to any central server or cloud-computing system via the border router 106 and the access point 110. The data communications can be carried out using any of a variety of custom or standard wireless protocols (e.g., Wi-Fi, ZigBee for low power, 6LoWPAN, Thread, etc.) and/or by using any of a variety of custom or standard wired protocols (CAT6 Ethernet, HomePlug, and so on).

Any of the wireless network devices in the HAN can serve as low-power and communication nodes to create the HAN in the home environment. Individual low-power nodes of the network can regularly send out messages regarding what they are sensing, and the other low-powered nodes in the environment - in addition to sending out their own messages - can repeat the messages, thereby communicating the messages from node to node (e.g., from device to device) throughout the home area network. The wireless network devices can be implemented to conserve power, particularly when battery-powered, utilizing low-powered communication protocols to receive the messages, translate the messages to other communication protocols, and send the translated messages to other nodes and/or to a central server or cloud-computing system. For example, the occupancy sensor 720 and/or an ambient light sensor 740 can detect an occupant in a room as well as measure the ambient light, and activate the light source when the ambient light sensor 740 detects that the room is dark and when the occupancy sensor 720 detects that someone is in the room. Further, the sensor can include a low-power wireless communication chip (e.g., an IEEE 802.15.4 chip, a Thread chip, a ZigBee chip) that regularly sends out messages regarding the occupancy of the room and the amount of light in the room, including instantaneous messages coincident with the occupancy sensor detecting the presence of a person in the room. As mentioned above, these messages may be sent wirelessly, using the home area network, from node to node (e.g., network-connected device to network-connected device) within the home environment as well as over the Internet to a central server or cloud-computing system.

In other configurations, various ones of the wireless network devices can function as "tripwires" for an alarm system in the home environment. For example, in the event a perpetrator circumvents detection by alarm sensors located at windows, doors, and other entry points of the structure or environment, the alarm could still be triggered by receiving an occupancy, motion, heat, sound, etc. message from one or more of the low-powered mesh nodes in the home area network. In other implementations, the home area network can be used to automatically turn on and off the lighting units 708 as a person transitions from room to room in the structure. For example, the wireless network devices can detect the person's movement through the structure and communicate corresponding messages via the nodes of the home area network. Using the messages that indicate which rooms are occupied, other wireless network devices that receive the messages can activate and/or deactivate accordingly. As referred to above, the home area network can also be utilized to provide exit lighting in the event of an emergency, such as by turning on the appropriate lighting units 708 that lead to a safe exit. The light units 708 may also be turned on to indicate the direction along an exit route that a person should travel to safely exit the structure.

The various wireless network devices may also be implemented to integrate and communicate with wearable computing devices 742, such as may be used to identify and locate an occupant of the structure and adjust the temperature, lighting, sound system, and the like accordingly. In other implementations, RFID sensing (e.g., a person having an RFID bracelet, necklace, or key fob), synthetic vision techniques (e.g., video cameras and face recognition processors), audio techniques (e.g., voice, sound pattern, vibration pattern recognition), ultrasound sensing/imaging techniques, and infrared or near-field communication (NFC) techniques (e.g., a person wearing an infrared or NFC-capable smartphone), along with rules-based inference engines or artificial intelligence techniques that draw useful conclusions from the sensed information as to the location of an occupant in the structure or environment.

In other implementations, personal comfort-area networks, personal health-area networks, personal safety-area networks, and/or other such human-facing functionalities of service robots can be enhanced by logical integration with other wireless network devices and sensors in the environment according to rules-based inferencing techniques or artificial intelligence techniques for achieving better performance of these functionalities. In an example relating to a personal health area, the system can detect whether a household pet is moving toward the current location of an occupant (e.g., using any of the wireless network devices and sensors), along with rules-based inferencing and artificial intelligence techniques. Similarly, a hazard detector service robot can be notified that the temperature and humidity levels are rising in a kitchen, and temporarily raise a hazard detection threshold, such as a smoke detection threshold, under an inference that any small increases in ambient smoke levels will most likely be due to cooking activity and not due to a genuinely hazardous condition. Any service robot that is configured for any type of monitoring, detecting, and/or servicing can be implemented as a mesh node device on the home area network, conforming to the wireless interconnection protocols for communicating on the home area network.

The wireless network devices 710 may also include a network-connected alarm clock 744 for each of the individual occupants of the structure in the home environment. For example, an occupant can customize and set an alarm device for a wake time, such as for the next day or week. Artificial intelligence can be used to consider occupant responses to the alarms when they go off and make inferences about preferred sleep patterns over time. An individual occupant can then be tracked in the home area network based on a unique signature of the person, which is determined based on data obtained from sensors located in the wireless network devices, such as sensors that include ultrasonic sensors, passive IR sensors, and the like. The unique signature of an occupant can be based on a combination of patterns of movement, voice, height, size, etc., as well as using facial or audio recognition techniques.

In an example of wireless interconnection, the wake time for an individual can be associated with the thermostat 702 to control the HVAC system in an efficient manner so as to pre-heat or cool the structure to desired sleeping and awake temperature settings. The preferred settings can be learned over time, such as by capturing the temperatures set in the thermostat before the person goes to sleep and upon waking up. Collected data may also include biometric indications of a person, such as breathing patterns, heart rate, movement, etc., from which inferences are made based on this data in combination with data that indicates when the person actually wakes up. Other wireless network devices can use the data to provide other automation objectives, such as adjusting the thermostat 702 so as to pre-heat or cool the environment to a desired setting and turning on or turning off the lighting units 708.

In implementations, the wireless network devices can also be utilized for sound, vibration, and/or motion sensing such as to detect running water and determine inferences about water usage in a home environment based on algorithms and mapping of the water usage and consumption. This can be used to determine a signature or fingerprint of each water source in the home and is also referred to as "audio fingerprinting water usage." Similarly, the wireless network devices can be utilized to detect the subtle sound, vibration, and/or motion of unwanted pests, such as mice and other rodents, as well as by termites, cockroaches, and other insects. The system can then notify an occupant of the suspected pests in the environment, such as with warning messages to help facilitate early detection and prevention.

The environment 700 may include one or more wireless network devices that function as a hub 746. The hub 746 (e.g., hub 120) may be a general-purpose home automation hub, or an application-specific hub, such as a security hub, an energy management hub, an HVAC hub, and so forth. The functionality of a hub 746 may also be integrated into any wireless network device, such as a network-connected thermostat device or the border router 106. Hosting functionality on the hub 746 in the structure 712 can improve reliability when the user's internet connection is unreliable, can reduce latency of operations that would normally have to connect to the cloud service 112, and can satisfy system and regulatory constraints around local access between wireless network devices.

Additionally, the example environment 700 includes a network-connected -speaker 748. The network-connected speaker 748 provides voice assistant services that include providing voice control of network-connected devices. The functions of the hub 746 may be hosted in the network-connected speaker 748. The network-connected speaker 748 can be configured to communicate via the HAN, which may include a wireless mesh network, a Wi-Fi network, or both.

FIG. 8 illustrates an example wireless network device 800 that can be implemented as any of the wireless network devices 102 (e.g., electronic device 202 or other target device) in a home area network in accordance with one or more aspects of right-to-repair battery-replacement methodologies and applications thereof as described herein. The device 800 can be integrated with electronic circuitry, microprocessors, memory, input/output (I/O) logic control, communication interfaces and components, as well as other hardware, firmware, and/or software to implement the device in a home area network. Further, the wireless network device 800 can be implemented with various components, such as with any number and combination of different components as further described with reference to the example device shown in FIG. 9.

In this example, the wireless network device 800 includes a low-power microprocessor 802 and a high-power microprocessor 804 (e.g., microcontrollers or digital signal processors) that process executable instructions. The device also includes an input-output (I/O) logic control 806 (e.g., to include electronic circuitry). The microprocessors can include components of an integrated circuit, programmable logic device, a logic device formed using one or more semiconductors, and other implementations in silicon and/or hardware, such as a processor and memory system implemented as a system-on-chip (SoC). Alternatively or in addition, the device can be implemented with any one or combination of software, hardware, firmware, or fixed logic circuitry that may be implemented with processing and control circuits. The low-power microprocessor 802 and the high-power microprocessor 804 can also support one or more different device functionalities of the device. For example, the high-power microprocessor 804 may execute computationally intensive operations, whereas the low-power microprocessor 802 may manage less-complex processes such as detecting a hazard or temperature from one or more sensors 808. The low-power microprocessor 802 may also wake or initialize the high-power microprocessor 804 for computationally intensive processes.

The one or more sensors 808 can be implemented to detect various properties such as acceleration, temperature, humidity, water, supplied power, proximity, external motion, device motion, sound signals, ultrasound signals, light signals, fire, smoke, carbon monoxide, global-positioning-satellite (GPS) signals, radio frequency (RF), other electromagnetic signals or fields, or the like. As such, the sensors 808 may include any one or a combination of temperature sensors, humidity sensors, hazard-related sensors, other environmental sensors, accelerometers, microphones, optical sensors up to and including cameras (e.g., charged coupled-device or video cameras, active or passive radiation sensors, GPS receivers, and radio frequency identification detectors. In implementations, the wireless network device 800 may include one or more primary sensors, as well as one or more secondary sensors, such as primary sensors that sense data central to the core operation of the device (e.g., sensing a temperature in a thermostat or sensing smoke in a smoke detector), while the secondary sensors may sense other types of data (e.g., motion, light or sound), which can be used for energy-efficiency objectives or automation objectives. In some aspects, the sensors 808 may include an ADC sensor configured to use an ADC integrated with the electronic device 202 to measure a voltage on one or more sense lines (e.g., sense line 320) or one or more pins coupled to the sense line(s). As described herein, the ADC sensor may (i) measure "1" on the sense line 320 when the sense line 320 is closed, indicating that the battery 204 is the originally installed battery or (i) measure a "0" when the sense line 320 is open (e.g., broken), which indicates that the battery 204 has been tampered with (e.g., removed and possibly replaced). The ADC sensor may also measure a second sense line connected to the enclosure of the electronic device 202. For example, the ADC sensor can (i) measure a "1" on the second sense line, which indicates that the enclosure has not been opened since factory assembly or (ii) measure a "0" when the second sense line is broken, which indicates that the enclosure has been opened.

The wireless network device 800 includes a memory device controller 810 and a memory device 812, such as any type of a nonvolatile memory and/or other suitable electronic data storage device. The wireless network device 800 can also include various firmware and/or software, such as an operating system 814 that is maintained as computer-executable instructions by the memory and executed by a microprocessor. The device software may also include a batterymanagement application 816 that implements aspects of right-to-repair battery-replacement methodologies and applications thereof. The wireless network device 800 also includes a device interface 818 to interface with another device or peripheral component and includes an integrated data bus 820 that couples the various components of the wireless network device for data communication between the components. The data bus in the wireless network device may also be implemented as any one or a combination of different bus structures and/or bus architectures.

The device interface 818 may receive input from a user and/or provide information to the user (e.g., as a user interface), and a received input can be used to determine a setting. The device interface 818 may also include mechanical or virtual components that respond to a user input. For example, the user can mechanically move a sliding or rotatable component, or the motion along a touchpad may be detected, and such motions may correspond to a setting adjustment of the device. Physical and virtual movable user-interface components can allow the user to set a setting along a portion of an apparent continuum. The device interface 818 may also receive inputs from any number of peripherals, such as buttons, a keypad, a switch, a microphone, and an imager (e.g., a camera device).

The wireless network device 800 can include network interfaces 822 (e.g., network interface 222), such as a home area network interface for communication with other wireless network devices in a home area network, and an external network interface for network communication, such as via the Internet. The wireless network device 800 also includes wireless radio systems 824 for wireless communication with other wireless network devices via the home area network interface and for multiple, different wireless communications systems. The wireless radio systems 824 may include Wi-Fi, Bluetooth^{™}, Mobile Broadband, BLE, and/or point-to-point IEEE 802.15.4. Each of the different radio systems can include a radio device, antenna, and chipset that is implemented for a particular wireless communications technology. The wireless network device 800 also includes a power source 826, such as a battery (e.g., battery 204) and/or a cable to connect the device to line voltage. An AC power source may also be used to charge the battery of the device.

FIG. 9 illustrates an example system 900 that includes an example device 902, which can be implemented as any of the wireless network devices 102 (e.g., electronic device 202 or other target device) that implement aspects of right-to-repair battery-replacement methodologies and applications thereof as described with reference to the previous FIGs. 1-8. The example device 902 may be any type of computing device, client device, mobile phone, tablet, communication, entertainment, gaming, media playback, and/or other type of device. Further, the example device 902 may be implemented as any other type of wireless network device that is configured for communication on a home area network, such as a thermostat, hazard detector, camera, light unit, commissioning device, router, border router, joiner router, joining device, end device, leader, access point, and/or other wireless network devices.

The device 902 includes communication devices 904 that enable wired and/or wireless communication of device data 906, such as data that is communicated between the devices in a home area network, data that is being received, data scheduled for broadcast, data packets of the data, data that is synched between the devices, etc. The device data can include any type of communication data, as well as audio, video, and/or image data that is generated by applications executing on the device. The communication devices 904 can also include transceivers for cellular phone communication and/or for network data communication.

The device 902 also includes input/output (I/O) interfaces 908, such as data network interfaces (e.g., network interface 222) that provide connection and/or communication links between the device, data networks (e.g., a home area network, external network, etc.), and other devices. The I/O interfaces can be used to couple the device to any type of components, peripherals, and/or accessory devices. The I/O interfaces also include data input ports via which any type of data, media content, and/or inputs can be received, such as user inputs to the device, as well as any type of communication data, as well as audio, video, and/or image data received from any content and/or data source.

The device 902 includes a processing system 910 (e.g., processors 206) that may be implemented at least partially in hardware, such as with any type of microprocessors, controllers, and the like that process executable instructions. The processing system can include components of an integrated circuit, programmable logic device, a logic device formed using one or more semiconductors, and other implementations in silicon and/or hardware, such as a processor and memory system implemented as a system-on-chip (SoC). Alternatively or in addition, the device can be implemented with any one or combination of software, hardware, firmware, or fixed logic circuitry that may be implemented with processing and control circuits. The device 902 may further include any type of a system bus or other data and command transfer system that couples the various components within the device. A system bus can include any one or combination of different bus structures and architectures, as well as control and data lines.

The device 902 also includes computer-readable storage memory 912 (e.g., CRM 208), such as data storage devices that can be accessed by a computing device, and that provide persistent storage of data and executable instructions (e.g., software applications, modules, programs, functions, and the like). The computer-readable storage memory described herein excludes propagating signals. Examples of computer-readable storage memory include volatile memory and non-volatile memory, fixed and removable media devices, and any suitable memory device or electronic data storage that maintains data for computing device access. The computer-readable storage memory can include various implementations of random access memory (RAM), read-only memory (ROM), flash memory, EPROM, EEPROM, and other types of storage memory in various memory device configurations.

The computer-readable storage memory 912 provides storage of the device data 906 and various device applications 914 (e.g., applications 210), such as an operating system (e.g., operating system 214) that is maintained as a software application with the computer-readable storage memory and executed by the processing system 910. The device applications 914 may also include a device manager, such as any form of a control application, software application, signal processing and control module, code that is native to a particular device, a hardware abstraction layer for a particular device, and so on. In this example, the device applications also include a device-management application 212 that implements aspects of right-to-repair battery-replacement methodologies and applications thereof, such as when the example device 902 is implemented as the electronic device 202 and the target device is remote and implemented as any of the wireless network devices described herein. In aspects, the device-management application 212 implements the identity-manager module 216, the battery-detection module 218, and the battery-characterization module 220 according to techniques described herein.

The device 902 also includes an audio and/or video system 916 that generates audio data for an audio device 918 and/or generates display data for a display device 920 (e.g., display 226). The audio device and/or the display device include any devices that process, display, and/or otherwise render audio, video, display, and/or image data, such as the image content of a digital photo. In implementations, the audio device and/or the display device are integrated components of the example device 902. Alternatively, the audio device and/or the display device are external, peripheral components to the example device. In aspects, at least part of the techniques described for right-to-repair battery-replacement methodologies and applications thereof may be implemented in a distributed system, such as over a "cloud" 922 in a platform 924. The cloud 922 includes and/or is representative of the platform 924 for services 926 and/or resources 928.

The platform 924 abstracts underlying functionality of hardware, such as server devices (e.g., included in the services 926) and/or software resources (e.g., included as the resources 928), and connects the example device 902 with other devices, servers, etc. The resources 928 may also include applications and/or data that can be utilized while computer processing is executed on servers that are remote from the example device 902. Additionally, the services 926 and/or the resources 928 may facilitate subscriber network services, such as over the Internet, a cellular network, or Wi-Fi network. The platform 924 may also serve to abstract and scale resources to service a demand for the resources 928 that are implemented via the platform, such as in an interconnected device aspect with functionality distributed throughout the system 900. For example, the functionality may be implemented in part at the example device 902 as well as via the platform 924 that abstracts the functionality of the cloud 922.

Some examples are described below:
A method for right-to-repair battery replacement for at least one electronic device, the method comprising: receiving a request to replace a battery in a target device with a replacement battery; receiving at least one image of a replacement-battery identification code associated with the replacement battery and of a target-device identification code associated with the target device; transmitting the replacement-battery identification code and the target-device identification code to a server; receiving a message of compatibility from the server indicating that the replacement battery is compatible with the target device based on the replacement-battery identification code and the target-device identification code; in response to receiving the message of compatibility from the server, instructing a user to replace the battery in the target device with the replacement battery; responsive to the target device being restarted, receiving an indication from the target device that a link configured to physically and electrically couple a device-side connector of the target device to a battery-side connector of the battery is open and that the replacement battery installed in the target device corresponds to the replacement-battery identification code in the at least one image; and based on the indication, notifying the user that the replacement battery was successfully installed in the target device.

The receiving a request and the receiving at least one image may be a single operation such that the request and the at least one image are concurrently received at the electronic device.

At least one of the replacement-battery identification code or the target-device identification code may be a machine-readable optical label.

The method may further comprise instructing the user to capture the at least one image using a camera; and the transmitting of the replacement-battery identification code and the target-device identification code may include transmitting the at least one image to the server.

The method may further comprise instructing the user to use the camera to capture a second image of the replacement battery; and transmitting the second image to the server for verification of the replacement-battery identification code.

The link may include at least one of a sense line or a fuse.

The method may further comprise receiving a notification from the target device indicating that the target device has been tampered with based on a detection of an additional link being broken, which indicates that an enclosure of the target device has been opened.

The method may further comprise: determining that the replacement battery has an electrically erasable programmable read-only memory, EEPROM, chip that stores a battery identifier for the replacement battery; and based on a determination that the battery identifier matches the replacement-battery identification code captured in the first image, instructing the user to keep the target device connected to an external power source for at least a threshold amount of time for characterization of the replacement battery.

The method may further comprise, based on a battery characterization profile generated during the threshold amount of time by running a charge/discharge profile on the replacement battery installed in the target device, notifying the user of a health status of the replacement battery.

The charge/discharge profile may include a step charge profile and a step discharge profile.

The battery characterization profile may represent the health status of the replacement battery based on a charge rate and a discharge rate of the replacement battery during execution of the charge/discharge profile.

The method may further comprise transmitting the battery characterization profile to the server for tracking the target device with respect to the replacement battery installed in the target device and for monitoring battery health of the replacement battery over a duration of time.

The method may further comprise, responsive to receiving the indication, determining that the replacement battery was successfully installed in the target device; and responsive to receiving the battery characterization profile, determining that the battery is safe for use in the target device.

The target device may be a wireless network device that is remote from the electronic device and communicatively coupled to the electronic device via a home area network.

The target device may be the electronic device such that the target device and the electronic device are a same device.

The method may further comprise recording the replacement battery as being designated to replace the battery within the target device.

An electronic device comprising: a camera system; a memory; and one or more processors configured to execute instructions in the memory to implement a device-management application configured to: communicate with the camera system to capture one or more images; and perform the method described above.

### Conclusion

Although aspects of right-to-repair battery-replacement methodologies and applications thereof have been described in language specific to features and/or methods, the subject of the appended claims is not necessarily limited to the specific features or methods described. Further, various different aspects are described, and it is to be appreciated that each described aspect can be implemented independently or in connection with one or more other described aspects.

## Claims

1. A method for right-to-repair battery replacement for at least one electronic device, the method comprising:
receiving, by an electronic device (202), a request to replace a battery (204) in a target device (102, 202) with a replacement battery;
in response to the request to replace the battery (204) in the target device (102, 202), instructing a user, by the electronic device (202), to capture images of a replacement-battery identification code associated with the replacement battery and a target-device identification code associated with the target device (102, 202);
receiving, by the electronic device (202), at least one image of the replacement-battery identification code and of the target-device identification code;
transmitting, by the electronic device (202), the replacement-battery identification code and the target-device identification code to a server;
receiving, by the electronic device (202), a message of compatibility from the server indicating that the replacement battery is compatible with the target device (102, 202) based on the replacement-battery identification code and the target-device identification code;
in response to receiving the message of compatibility from the server, instructing a user, by the electronic device (202), to replace the battery (204) in the target device (102, 202) with the replacement battery;
responsive to the target device (102, 202) being restarted, receiving, by the electronic device (202), an indication from the target device (102, 202) that a link configured to physically and electrically couple a device-side connector (304) of the target device (102, 202) to a battery-side connector (302) of the battery (204) is open and an indication that the replacement battery installed in the target device (102, 202) corresponds to the replacement-battery identification code in the at least one image; and
determining and notifying the user, by the electronic device (202), that the replacement battery was successfully installed in the target device (102, 202) based on the receipt of both indications.

2. The method of claim 1, wherein the receiving a request and the receiving at least one image are a single operation such that the request and the at least one image are concurrently received at the electronic device.

3. The method of claim 1 or claim 2, wherein at least one of the replacement-battery identification code or the target-device identification code is a machine-readable optical label.

4. The method of any one of claims 1 to 3, wherein:
the method further comprises instructing the user, by the electronic device (202), to capture the at least one image using a camera (224); and
the transmitting of the replacement-battery identification code and the target-device identification code includes transmitting the at least one image to the server.

5. The method of claim 4, further comprising:
instructing the user, by the electronic device (202), to use the camera (224) to capture a second image of the replacement battery; and
transmitting, by the electronic device (202), the second image to the server for verification of the replacement-battery identification code.

6. The method of any one of claims 1 to 5, wherein the link comprises at least one of a sense line (320) or a fuse.

7. The method of any one of claims 1 to 6, further comprising receiving a notification, by the electronic device (202), from the target device (102) indicating that the target device (102) has been tampered with based on a detection of an additional link being broken, which indicates that an enclosure of the target device (102) has been opened.

8. The method of any one of claims 1 to 7, further comprising:
determining, by the electronic device (202), that the replacement battery has an electrically erasable programmable read-only memory, EEPROM, chip that stores a battery identifier for the replacement battery; and
based on a determination that the battery identifier matches the replacement-battery identification code captured in the first image, instructing the user, by the electronic device (202), to keep the target device (102, 202) connected to an external power source for at least a threshold amount of time for characterization of the replacement battery.

9. The method of claim 8, further comprising:
based on a battery characterization profile generated during the threshold amount of time by running a charge/discharge profile on the replacement battery installed in the target device (102, 202), notifying the user, by the electronic device (202), of a health status of the replacement battery.

10. The method of claim 9, wherein the battery characterization profile represents the health status of the replacement battery based on a charge rate and a discharge rate of the replacement battery during execution of the charge/discharge profile.

11. The method of any one of claim 9 or claim 10, further comprising transmitting, by the electronic device (202), the battery characterization profile to the server for tracking the target device (102, 202) with respect to the replacement battery installed in the target device (102, 202) and for monitoring battery health of the replacement battery over a duration of time.

12. The method of any one of claims 9 to 11, further comprising:
responsive to receiving the indication, determining, by the electronic device (202), that the replacement battery was successfully installed in the target device (102, 202); and
responsive to receiving the battery characterization profile, determining, by the electronic device (202), that the battery (204) is safe for use in the target device (102, 202).

13. The method of any one of claims 1 to 12, wherein the target device (102) is a wireless network device that is remote from the electronic device (202) and communicatively coupled to the electronic device (202) via a home area network.

14. The method of any one of claims 1 to 13, wherein the target device (202) is the electronic device.

15. An electronic device comprising:
a camera system (224);
a memory; and
one or more processors (206) configured to execute instructions in the memory to implement a device-management application configured to:
communicate with the camera system (224) to capture one or more images; and
perform the method of any one of claims 1 to 14.

## Patentansprüche

1. Verfahren zur reparaturgerechten Batterieersetzung für mindestens eine elektronische Vorrichtung, wobei das Verfahren Folgendes umfasst:
Empfangen einer Anforderung durch eine elektronische Vorrichtung (202) zum Ersetzen einer Batterie (204) in einer Zielvorrichtung (102, 202) durch eine Ersatzbatterie;
als Reaktion auf die Anforderung zum Ersetzen der Batterie (204) in der Zielvorrichtung (102, 202), Anweisen eines Benutzers durch die elektronische Vorrichtung (202), Bilder eines der Ersatzbatterie zugeordneten Identifikationscodes der Ersatzbatterie und eines der Zielvorrichtung (102, 202) zugeordneten Identifikationscodes der Zielvorrichtung aufzunehmen;
Empfangen mindestens eines Bildes des Identifikationscodes der Ersatzbatterie und des Identifikationscodes der Zielvorrichtung durch die elektronische Vorrichtung (202);
Übertragen des Identifikationscodes der Ersatzbatterie und des Identifikationscodes der Zielvorrichtung an einen Server durch die elektronische Vorrichtung (202);
Empfangen einer Kompatibilitätsmeldung von dem Server durch die elektronische Vorrichtung (202), die angibt, dass die Ersatzbatterie mit der Zielvorrichtung (102, 202) kompatibel ist, und zwar basierend auf dem Identifikationscode der Ersatzbatterie und dem Identifikationscode der Zielvorrichtung; als Reaktion auf das Empfangen der Kompatibilitätsmeldung von dem Server, Anweisen eines Benutzers durch die elektronische Vorrichtung (202), die Batterie (204) in der Zielvorrichtung (102, 202) durch die Ersatzbatterie zu ersetzen;
als Reaktion darauf, dass die Zielvorrichtung (102, 202) neu gestartet wird, Empfangen durch die elektronische Vorrichtung (202) einer Angabe von der Zielvorrichtung (102, 202), dass eine Verbindung, die konfiguriert ist, um einen vorrichtungsseitigen Anschluss (304) der Zielvorrichtung (102, 202) physisch und elektrisch mit einem batterieseitigen Anschluss (302) der Batterie (204) zu koppeln, offen ist, und einer Angabe, dass die in die Zielvorrichtung (102, 202) eingebaute Ersatzbatterie dem Identifikationscode der Ersatzbatterie in dem mindestens einen Bild entspricht; und
Bestimmen und Benachrichtigen des Benutzers durch die elektronische Vorrichtung (202), dass die Ersatzbatterie basierend auf dem Empfang beider Angaben erfolgreich in die Zielvorrichtung (102, 202) installiert wurde.

2. Verfahren nach Anspruch 1, wobei das Empfangen einer Anforderung und das Empfangen mindestens eines Bildes einen einzigen Vorgang darstellen, sodass die Anforderung und das mindestens eine Bild gleichzeitig bei der elektronischen Vorrichtung empfangen werden.

3. Verfahren nach Anspruch 1 oder Anspruch 2, wobei mindestens eines von dem Identifikationscode der Ersatzbatterie oder dem Identifikationscode der Zielvorrichtung ein maschinenlesbares optisches Etikett ist.

4. Verfahren nach einem der Ansprüche 1 bis 3, wobei:
das Verfahren ferner das Anweisen des Benutzers durch die elektronische Vorrichtung (202), das mindestens eine Bild unter Verwendung einer Kamera (224) aufzunehmen, umfasst; und
das Übertragen des Identifikationscodes der Ersatzbatterie und des Identifikationscodes der Zielvorrichtung das Übertragen des mindestens einen Bildes an den Server beinhaltet.

5. Verfahren nach Anspruch 4, ferner umfassend:
Anweisen des Benutzers durch die elektronische Vorrichtung (202), die Kamera (224) zu verwenden, um ein zweites Bild der Ersatzbatterie aufzunehmen; und
Übertragen des zweiten Bildes durch die elektronische Vorrichtung (202) an den Server zur Überprüfung des Identifikationscodes der Ersatzbatterie.

6. Verfahren nach einem der Ansprüche 1 bis 5, wobei die Verbindung mindestens eines von einer Messleitung (320) oder einer Sicherung umfasst.

7. Verfahren nach einem der Ansprüche 1 bis 6, ferner umfassend Empfangen einer Benachrichtigung durch die elektronische Vorrichtung (202) von der Zielvorrichtung (102), die angibt, dass die Zielvorrichtung (102) manipuliert wurde, basierend auf einer Detektion einer unterbrochenen zusätzlichen Verbindung, was angibt, dass ein Gehäuse der Zielvorrichtung (102) geöffnet wurde.

8. Verfahren nach einem der Ansprüche 1 bis 7, ferner umfassend:
Bestimmen durch die elektronische Vorrichtung (202), dass die Ersatzbatterie über einen elektrisch löschbaren programmierbaren Nur-Lese-Speicher (EEPROM)-Chip verfügt, auf dem eine Batteriekennung für die Ersatzbatterie gespeichert ist; und
basierend auf einer Bestimmung, dass die Batteriekennung mit dem in dem ersten Bild aufgenommenen Identifikationscode der Ersatzbatterie übereinstimmt, Anweisen des Benutzers durch die elektronische Vorrichtung (202), die Zielvorrichtung (102, 202) für mindestens eine Schwellenzeitdauer an eine externe Stromquelle angeschlossen zu lassen, um die Ersatzbatterie zu charakterisieren.

9. Verfahren nach Anspruch 8, ferner umfassend:
basierend auf einem Batteriecharakterisierungsprofil, das während der Schwellenzeitdauer durch Ausführen eines Lade-/Entladeprofils an der in der Zielvorrichtung (102, 202) eingebauten Ersatzbatterie erzeugt wurde, Benachrichtigen des Benutzers durch die elektronische Vorrichtung (202) über den Zustand der Ersatzbatterie.

10. Verfahren nach Anspruch 9, wobei das Batteriecharakterisierungsprofil den Zustand der Ersatzbatterie basierend auf einer Laderate und einer Entladerate der Ersatzbatterie während der Ausführung des Lade-/Entladeprofils darstellt.

11. Verfahren nach einem der Ansprüche 9 oder Anspruch 10, ferner umfassend Übertragen des Batteriecharakterisierungsprofils durch die elektronische Vorrichtung (202) an den Server, um die Zielvorrichtung (102, 202) hinsichtlich der in der Zielvorrichtung (102, 202) installierten Ersatzbatterie zu verfolgen und den Batteriezustand der Ersatzbatterie über einen bestimmten Zeitraum hinweg zu überwachen.

12. Verfahren nach einem der Ansprüche 9 bis 11, ferner umfassend:
als Reaktion auf Empfangen der Angabe, Bestimmen durch die elektronische Vorrichtung (202), dass die Ersatzbatterie erfolgreich in die Zielvorrichtung (102, 202) installiert wurde; und als Reaktion auf Empfangen des Batteriecharakterisierungsprofils, Bestimmen durch die elektronische Vorrichtung (202), dass die Batterie (204) in der Zielvorrichtung (102, 202) sicher verwendbar ist.

13. Verfahren nach einem der Ansprüche 1 bis 12, wobei die Zielvorrichtung (102) eine drahtlose Netzwerkvorrichtung ist, die von der elektronischen Vorrichtung (202) entfernt ist und über ein Heimnetzwerk kommunikativ mit der elektronischen Vorrichtung (202) gekoppelt ist.

14. Verfahren nach einem der Ansprüche 1 bis 13, wobei die Zielvorrichtung (202) die elektronische Vorrichtung ist.

15. Elektronische Vorrichtung, umfassend:
ein Kamerasystem (224);
einen Speicher; und
einen oder mehrere Prozessoren (206), die konfiguriert sind, um Anweisungen in dem Speicher auszuführen, um eine Vorrichtungsverwaltungsanwendung zu implementieren, die konfiguriert ist zum:
Kommunizieren mit dem Kamerasystem (224), um ein oder mehrere Bilder aufzunehmen; und
Durchführen des Verfahrens nach einem der Ansprüche 1 bis 14.

## Revendications

1. Procédé de remplacement de batterie à droit à la réparation pour au moins un dispositif électronique, le procédé comprenant :
la réception, par un dispositif électronique (202), d'une demande de remplacement d'une batterie (204) dans un dispositif cible (102, 202) par une batterie de remplacement ;
en réponse à la demande de remplacement de la batterie (204) dans le dispositif cible (102, 202), le fait d'ordonner à un utilisateur, par le dispositif électronique (202), de capturer des images d'un code d'identification de remplacement de batterie associé à la batterie de remplacement et d'un code d'identification de dispositif cible associé au dispositif cible (102, 202) ;
la réception, par le dispositif électronique (202), d'au moins une image du code d'identification de remplacement de batterie et du code d'identification de dispositif cible ;
la transmission, par le dispositif électronique (202), du code d'identification de remplacement de batterie et du code d'identification de dispositif cible à un serveur ;
la réception, par le dispositif électronique (202), d'un message de compatibilité en provenance du serveur indiquant que la batterie de remplacement est compatible avec le dispositif cible (102, 202) sur la base du code d'identification de remplacement de batterie et du code d'identification de dispositif cible ;
en réponse à la réception du message de compatibilité en provenance du serveur, le fait d'ordonner à un utilisateur, par le dispositif électronique (202), de remplacer la batterie (204) dans le dispositif cible (102, 202) par la batterie de remplacement ;
en réponse au redémarrage du dispositif cible (102, 202), la réception, par le dispositif électronique (202), d'une indication en provenance du dispositif cible (102, 202) qu'une liaison configurée pour coupler physiquement et électriquement un connecteur côté dispositif (304) du dispositif cible (102, 202) à un connecteur côté batterie (302) de la batterie (204) est ouverte et d'une indication que la batterie de remplacement installée dans le dispositif cible (102, 202) correspond au code d'identification de batterie de remplacement dans l'au moins une image ; et
le fait de déterminer et de notifier à l'utilisateur, par le dispositif électronique (202), que la batterie de remplacement a été installée avec succès dans le dispositif cible (102, 202) sur la base de la réception des deux indications.

2. Procédé selon la revendication 1, dans lequel la réception d'une demande et la réception d'au moins une image sont une seule opération, de telle sorte que la demande et l'au moins une image sont reçues simultanément au niveau du dispositif électronique.

3. Procédé selon la revendication 1 ou la revendication 2, dans lequel au moins l'un du code d'identification de remplacement de batterie ou du code d'identification de dispositif cible est une étiquette optique lisible par machine.

4. Procédé selon l'une quelconque des revendications 1 à 3, dans lequel :
le procédé comprend en outre le fait d'ordonner à l'utilisateur, par le dispositif électronique (202), de capturer l'au moins une image à l'aide d'une caméra (224) ; et
la transmission du code d'identification de remplacement de batterie et du code d'identification de dispositif cible comporte la transmission de l'au moins une image au serveur.

5. Procédé selon la revendication 4, comprenant en outre :
le fait d'ordonner à l'utilisateur, par le dispositif électronique (202), d'utiliser la caméra (224) pour capturer une seconde image de la batterie de remplacement ; et
la transmission, par le dispositif électronique (202), de la seconde image au serveur pour vérifier le code d'identification de remplacement de batterie.

6. Procédé selon l'une quelconque des revendications 1 à 5, dans lequel la liaison comprend au moins l'un d'une ligne de détection (320) ou d'un fusible.

7. Procédé selon l'une quelconque des revendications 1 à 6, comprenant en outre la réception, par le dispositif électronique (202), d'une notification en provenance du dispositif cible (102) indiquant que le dispositif cible (102) a été altéré sur la base de la détection qu'une liaison supplémentaire est rompue, ce qui indique qu'un boîtier du dispositif cible (102) a été ouvert.

8. Procédé selon l'une quelconque des revendications 1 à 7, comprenant en outre :
le fait de déterminer, par le dispositif électronique (202), que la batterie de remplacement a une puce de mémoire morte programmable et effaçable électriquement, EEPROM, qui stocke un identifiant de batterie pour la batterie de remplacement ; et
sur la base d'une détermination selon laquelle l'identifiant de batterie correspond au code d'identification de remplacement de batterie capturé dans la première image, le fait d'ordonner à l'utilisateur, par le dispositif électronique (202), de garder le dispositif cible (102, 202) connecté à une source d'alimentation externe pendant au moins une durée seuil pour la caractérisation de la batterie de remplacement.

9. Procédé selon la revendication 8, comprenant en outre :
sur la base d'un profil de caractérisation de batterie généré au cours de la durée seuil en exécutant un profil de charge/décharge sur la batterie de remplacement installée dans le dispositif cible (102, 202), le fait de notifier à l'utilisateur, par le dispositif électronique (202), d'un état de santé de la batterie de remplacement.

10. Procédé selon la revendication 9, dans lequel le profil de caractérisation de batterie représente l'état de santé de la batterie de remplacement sur la base d'un taux de charge et d'un taux de décharge de la batterie de remplacement au cours de l'exécution du profil de charge/décharge.

11. Procédé selon l'une quelconque de la revendication 9 ou de la revendication 10, comprenant en outre la transmission, par le dispositif électronique (202), du profil de caractérisation de batterie au serveur pour suivre le dispositif cible (102, 202) par rapport à la batterie de remplacement installée dans le dispositif cible (102, 202) et pour surveiller la santé de batterie de la batterie remplacement sur une durée donnée.

12. Procédé selon l'une quelconque des revendications 9 à 11, comprenant en outre :
en réponse à la réception de l'indication, le fait de déterminer, par le dispositif électronique (202), que la batterie de remplacement a été installée avec succès dans le dispositif cible (102, 202) ; et
en réponse à la réception du profil de caractérisation de batterie, le fait de déterminer, par le dispositif électronique (202), que la batterie (204) est sûre pour une utilisation dans le dispositif cible (102, 202).

13. Procédé selon l'une quelconque des revendications 1 à 12, dans lequel le dispositif cible (102) est un dispositif de réseau sans fil qui est distant du dispositif électronique (202) et couplé de manière communicative au dispositif électronique (202) via un réseau domestique.

14. Procédé selon l'une quelconque des revendications 1 à 13, dans lequel le dispositif cible (202) est le dispositif électronique.

15. Dispositif électronique comprenant :
un système de caméra (224) ;
une mémoire ; et
un ou plusieurs processeurs (206) configurés pour exécuter des instructions dans la mémoire pour mettre en œuvre une application de gestion de dispositif configurée pour :
communiquer avec le système de caméra (224) pour capturer une ou plusieurs images ; et
réaliser le procédé selon l'une quelconque des revendications 1 à 14.
